# EUROPÄISCHE PATENTANMELDUNG

(11) **EP 0 537 750 A1**
(43) Veröffentlichungstag der Anmeldung: **21.04.1993**
(21) Anmeldenummer: 92117646.7
(22) Anmeldetag: 15.10.1992
(51) Int. Cl.: H03D 3/00, H03C 3/40

(54) **Schaltungsanordnung zur Quadraturmodulation bzw. Quadraturdemodulation**

(30) Priorität: 15.10.1991 DE 4134128
(71) Anmelder: SIEMENS AKTIENGESELLSCHAFT, D-80333 München (DE)
(72) Erfinder: Fenk, Josef, Dipl.-Ing., W-8057 Eching/Ottenburrg (DE); Sehrig, Peter, Ing., W-8134 Pöcking (DE)

(57) **Zusammenfassung**

Schaltungsanordnung zur Quadraturmodulation bzw. Quadraturdemodulation mit einem lokalen Oszillator (LO) zur Erzeugung eines Ausgangssignals von bestimmter Frequenz, mit einem dem lokalen Oszillator (LO) nachgeschalteten Phasenschieber (PS) zur Erzeugung zweier orthogonaler Trägersignale, mit einem Verstärker (AGC) mit gegebener oberer Grenzfrequenz, der mit einem Informationssignal angesteuert wird, und mit zwei Multiplizierern (MI, MQ), die das Ausgangssignal des Verstärkers (AGC) mit jeweils einem orthogonalen Trägersignal multiplizieren, wobei die Frequenz des Ausgangssignals des lokalen Oszillators (LO) höher ist als die obere Grenzfrequenz des Verstärkers (AGC), und zwischen lokalen Oszillator (LO) und Phasenschieber (PS) ein Frequenzteiler (FT) geschaltet ist.

## Beschreibung

Die Erfindung betrifft eine Schaltungsanordnung zur Quadraturmodulation bzw. Quadraturdemodulation nach dem Oberbegriff des Patentanspruches 1.

Quadraturmodulation und -demodulation kommen insbesondere bei digitalen Mobilfunknetzen zur Anwendung. Dabei wird im wesentlichen ein bandbegrenztes Informationssignal mit jeweils einer von zwei orthogonalen Komponenten eines Trägersignals multipliziert. Üblicherweise sind dafür ein Oszillator, der das Trägersignal erzeugt, und ein diesem nachgeschalteter Phasenschieber, der das Trägersignal in die beiden orthogonalen Komponenten zerlegt, vorgesehen. Darüber hinaus wird das Informationssignal über einen Verstärker mit Tiefpaß- oder Bandpaßverhalten auf zwei Multiplizierer geführt, die zudem jeweils mit einem der beiden orthogonalen Komponenten des Trägersignals angesteuert werden. Eine derartige Schaltungsanordnung ist beispielsweise aus dem Datenblatt PMB 2400-GSM Receiver Circuit, Ausgabe Oktober 1990, Siemens AG, bekannt.

Probleme treten dabei jedoch auf, wenn - wie es häufig der Fall ist - die Frequenz des Oszillators in den Durchlaßbereich des bandbegrenzten Verstärkers fällt. Dann nämlich tritt aufgrund einer insbesondere kapazitiven Kopplung zwischen Oszillator und Verstärker ein Übersprechen des Trägersignals auf den Verstärker auf, was zu unerwünschten Offsetsignalen an den Ausgängen der Multiplizierer führt. Vor allem ein großes Ausgangssignal des Oszillators und eine hohe Gesamtverstärkung des Verstärkers begünstigen im Normalfall diesen Effekt. Eine Verringerung des Kopplungsfaktors zwischen Verstärker und Oszillator gestaltet sich im allgemeinen sehr schwierig.

Aufgabe der Erfindung ist es, eine Schaltungsanordnung zur Quadraturmodulation anzugeben, bei der das Übersprechen des Trägersignals auf den Verstärker geringer ist.

Die vorstehend aufgezeigte Aufgabe wird bei einer gattungsgemäßen Schaltungsanordnung durch die kennzeichnenden Merkmale des Patentanspruches 1 gelöst.

Vorteil der erfindungsgemäßen Schaltungsanordnung ist es, daß mit geringem schaltungstechnischen Aufwand eine Verringerung unerwünschter Offsetsignale erzielt wird.

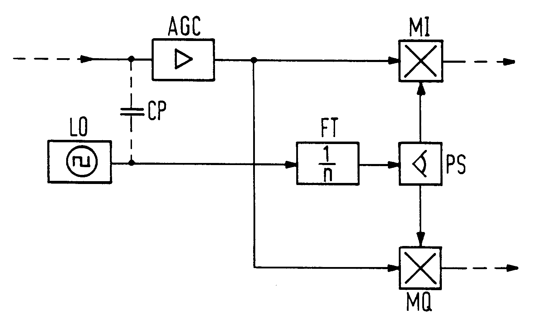

Die Erfindung wird nachfolgend anhand des in der einzigen Figur der Zeichnung dargestellten Ausführungsbeispiels näher erläutert.

Eine erfindungsgemäße Schaltungsanordnung zur Quadraturmodulation bzw. Demodulation enthält, wie in der Zeichnung gezeigt, einen lokalen Oszillator LO, der ein Ausgangssignal von bestimmter Frequenz erzeugt. Dem lokalen Osziallator LO ist ein Frequenzteiler FT mit einem Teilungsverhältnis 1/n und diesen wiederum ein Phasenschieber PS nachgeschaltet. Der Phasenschieber PS spaltet ein an seinem Eingang anliegendes Signal in zwei zueinander um 90° phasenverschobene Komponenten auf, die im folgenden als orthogonale Trägersignale bezeichnet werden. Mit den beiden orthogonalen Trägersignalen werden jeweils ein Multiplizierer MI und MQ angesteuert, die das Ausgangssignal eines Verstärkers AGC mit jeweils einem der beiden orthogonalen Trägersignale multiplizieren. Der Verstärker AGC weist eine gegebene obere Grenzfrequenz auf und ist eingangsseitg mit einem Informationssignal beaufschlagt.

Bei dem vorliegenden Ausführungsbeispiel sei der Verstärker AGC durch einen Regelverstärker mit Bandpaßverhalten gegeben. Grundsätzlich ist jedoch jeder Verstärker geeignet. Bedarfsweise kann dabei die obere Grenzfrequenz des Verstärkers durch entsprechende Maßnahmen herabgesetzt sein. Der Verstärker AGC. des Ausführungsbeispiels weist einen Durchlaßbereich von 30 MHz bis 100 MHz auf. Für die beiden orthogonalen Trägersignale sei eine Frequenz von 45 MHz gefordert. Unter der Annahme, daß es sich bei dem Phasenschieber PS um einen Phasenschieber nach dem Teilerprinzip handelt, der neben der Aufspaltung seines Eingangssignals in zwei orthogonale Komponenten darüber hinaus eine Frequenzteilung durch 2 durchführt, ergibt sich für das Ausgangssignal des lokalen Oszillators LO eine Frequenz von 90 MHz. Die Frequenz des Ausgangssignals des lokalen Oszillators LO fällt damit jedoch in den Durchlaßbereich des Verstärkers AGC. Aufgrund einer parasitären Kopplung des Ausgangs des lokalen Oszillators LO und des Eingangs des Verstärkers AGC, die beispielsweise als parasitäre Kapazität CP beschrieben werden kann, würde das Ausgangssignal des lokalen Oszillators LO in den Verstärker AGC eingespeist werden. Dadurch entstünden an den Ausgängen der beiden Multiplizierer MI und MQ unerwünschte Offsetsignale.

Erfindungsgemäß wird nun die Frequenz des Ausgangssignals des lokalen Oszillators LO so gewählt, daß diese größer ist als die obere Grenzfrequenz des Verstärkers AGC, also beim vorliegenden Ausführungsbeispiel größer als 100 MHz. Die Frequenz des Ausgangssignals des lokalen Oszillators LO wird also beispielsweise gleich 180 MHz bzw. 360 MHz festgesetzt. Das Teilungsverhältnis 1/n des Frequenzteilers FT ergibt sich damit zu 1/2 bzw. 1/4, so daß einschließlich des Teilungsverhältnisses 1/2 des Phasenschiebers PS für die beiden orthogonalen Trägersignale die gewünschte Frequenz von 45 MHz erzielt wird.

Wird als lokaler Oszillator LO ein steuerbarer Oszillator verwendet, der einen bestimmten Frequenzbereich überstreicht, so ist davon auszugehen, daß die niedrigste Frequenz des Ausgangssignals des lokalen Osziallators LO höher ist als die obere Grenzfrequenz des Verstärkers AGC. Wie hoch die Frequenz des Ausgangssignals des lokalen Oszillators LO gewählt wird, hängt zum einen von der Steilheit der oberen Flanke des Verstärkers AGC ab und zum anderen von der gewünschten Dämpfung der Offsetsignale.

## Patentansprüche

1. Schaltungsanordnung zur Quadraturmodulation bzw. Demodulation
mit einem lokalen Oszillator (LO) zur Erzeugung eines Ausgangssignals von bestimmter Frequenz,
mit einem dem lokalen Oszillator (LO) nachgeschalteten Phasenschieber (PS) zur Erzeugung zweier orthogonaler Trägersignale, mit einem Verstärker (AGC) mit gegebener oberer Grenzfrequenz, der mit einem Informationssignal angesteuert wird, und mit zwei Multiplizierern (MI, MQ), die das Ausgangssignal des Verstärkers (AGC) mit jeweils einem orthogonalen Trägersignal multiplizieren, **dadurch gekennzeichnet,** daß die Frequenz des Ausgangssignals des lokalen Oszillators (LO) höher ist als die obere Grenzfrequenz des Verstärkers (AGC), und daß zwischen lokalen Oszillator (LO) und Phasenschieber (PS) ein Frequenzteiler (FT) geschaltet.
